# EUROPÄISCHE PATENTSCHRIFT

(11) **EP 2 854 296 B1**
(45) Veröffentlichungstag und Bekanntmachung des Hinweises auf die Patenterteilung: **13.12.2017**
(21) Anmeldenummer: 13004691.5
(22) Anmeldetag: 27.09.2013
(51) Int. Cl.: H03K 17/97, H03K 17/95

(54) **Kontaktloser Taster**
Contactless switch
Bouton sans contact

(43) Veröffentlichungstag der Anmeldung: 01.04.2015
(73) Patentinhaber: Contelec AG, 2503 Biel/Bienne (CH)
(72) Erfinder: Bachmann, Rolf, 3292 Busswil BE (CH)
(74) Vertreter: Jakelski & Althoff Patentanwälte PartG mbB

(56) Entgegenhaltungen:
- EP-A2- 1 270 328
- DE-A1-102010 002 109
- DE-B3-102009 053 676
- DE-U1- 29 905 431

## Beschreibung

Die vorliegende Erfindung betrifft einen kontaktlosen elektrischen Taster, insbesondere einen Taster mit magnetischer Rückstellfunktion.

### Stand der Technik

Es sind elektronische Druckknöpfe beziehungsweise Taster bekannt, die zwei Kontaktzonen über ein Kurzschlussstück verbinden. Um ein sicheres Schalten zu erreichen und dem Betätiger ein haptisches Feedback zu geben, werden solche Taster oft mit einer sogenannten Klickfunktion ausgeführt. Diese kann beispielsweise durch eine gebogene Folie realisiert werden, die unter ausreichendem Druck auf die Taste des Tasters eine sprunghafte Durchbiegung zulässt, welche beim Loslassen der Taste reversibel ist. Solche Taster können beispielsweise als Folientastatur mit einzelnen oder mehreren Tasten ausgeführt sein. Eine derartige Tastatur ist aus der EP 0 841 674 B1 bekannt.

Weiterhin ist es bekannt, Taster mit einem mechanischen Federsystem zu versehen, um ein Rückstellen der gedrückten Taste zu ermöglichen. Auch hierbei wird ein Drücken der Taste durch eine mechanische Kontaktierung erkannt.

Ein Verzicht auf eine mechanische Kontaktierung ist für sogenannte berührungslose Taster bekannt, die die Betätigung ihrer Taste mit Reed-Kontakten erkennen. Hierbei führt das Feld eines Permanentmagneten dazu, dass sich Kontaktzonen aus magnetischem Material berühren und so einen elektrischen Kontakt herstellen. Es erfolgt also eine kontaktlose Betätigung, durch die allerdings immer noch ein mechanischer, elektrischer Kontakt hergestellt wird.

Ein vollständig berührungsloser Taster ist aus der DE 102 41 642 A1 bekannt. Seine Taste besteht aus einem permanentmagnetischen Material und haftet in einer Ruheposition magnetisch an einer Haftplatte. Wird Druck auf die Taste ausgeübt, so kann sie von der Haftplatte abgelöst und durch einen von seitlich neben der Taste angeordneten Hall-Sensoren überwachten Bereich bewegt werden. Zur Unterbringung dieser Hall-Sensoren weist der Taster eine große Breite auf.

Ein Kombinationsschalter mit einem Hebelelement, welches betätigbar ist, um relativ zu einer stationären Position bewegt zu werden, und einem Positionsdetektor, welcher die Position des Hebelelements detektiert, ist bereits aus der EP 1 270 328 A2 bekannt. Hierin gibt ein Halleffektsensor in Abhängigkeit einer positionsändernden Größe des Hebelelements eine zu der zu messenden Magnetfeldstärke lineare oder nichtlineare Charakteristik aus.

Aus der DE 10 2010 002 109 A1 ist ein Sensorelement mit einem magnetflusssensitiven Aufnehmer, einem Ringmagneten sowie einem Flussleitelement zur Verwendung in einer Druckdose bekannt. Der Ringmagnet ist in axialer Richtung magnetisiert und der Aufnehmer ist zur Erfassung der axialen Relativstellung des Ringmagneten zum Aufnehmer vorgesehen. In einer Ausführungsform erzeugt eine Auswerteeinrichtung ein linearisiertes Ausgangssignal, welches mit der axialen Relativstellung von Aufnehmer und Ringmagnet korrespondiert.

Aus der DE 10 2009 053 676 B3 ist eine Einstellvorrichtung mit Raster bekannt, welche der manuellen Einstellung eines Sollwertes mit einem Drehknopf dient. Dabei erfasst eine Sensoreinheit die Drehstellung des Drehknopfes bzw. der mit dem Drehknopf bewegungsverbundenen ersten Permanentmagneteinrichtung dadurch, dass die Orientierung der von der ersten Permanentmagneteinrichtung sich erstreckenden Feldlinien erfasst wird. Hierbei wird eine Rückstellkraft durch einen zweiten Magneten realisiert. Aus der DE 299 05 431 U1 ist ein Taster bekannt, bei dem der Sensor außerhalb eines ringförmigen Permanentmagneten angeordnet ist und bei dem ein ferromagnetisches Element zusammen mit dem Ringmagneten eine Rückstellkraft bewirkt.

Es ist Aufgabe der vorliegenden Erfindung, einen kompakten vollständig berührungslos aufgebauten Taster bereit zu stellen der insbesondere eine Klickfunktion aufweist und eine gute magnetische Abschirmung aufweist, so dass mehrere derartige Taster störungsfrei nebeneinander angeordnet werden können.

### Offenbarung der Erfindung

Diese Aufgabe wird durch den erfindungsgemäßen Taster gelöst. Dieser umfasst eine Taste, die mit einem ringförmigen Permanentmagneten verbunden ist, der entlang einer Z-Achse magnetisiert ist. Des Weiteren umfasst er eine Führung aus einem nicht ferromagnetischen Material, in der die Taste und der ringförmige Permanentmagnet entlang der z-Achse bewegbar angeordnet sind. Außerdem umfasst er mindestens einen Sensor, dessen sensitiver Bereich im ringförmigen Permanentmagneten angeordnet ist. Der Sensor ist eingerichtet, um eine Änderung eines magnetischen Feldes in radialer Richtung in einer x-y-Ebene zu messen. Die x-Achse und die y-Achse stehen jeweils orthogonal auf der z-Achse. Die Messung des magnetischen Feldes erfolgt in radialer Richtung, da bedingt durch die Ringform des Magneten die magnetischen Feldlinien von und zum Ringzentrum des Magneten verlaufen. Der mindest eine Sensor kann die Veränderung des vom ringförmigen Permanentmagneten erzeugten magnetischen Feldes während der Betätigung der Taste in ein elektrisches Signal umwandeln. Dies ermöglicht eine kontaktlose Messung einer Betätigung der Taste, sodass der erfindungsgemäße Taster keiner Abnutzung unterliegt. Die Anordnung des sensitiven Bereiches des Sensors in dem ringförmigen Permanentmagneten führt zu einer sehr kompakten Bauweise des Tasters. Gleichzeitig kann eine Bewegung des ringförmigen Permanentmagneten dadurch sehr genau bestimmt werden. Aufgrund der Polarisierung des ringförmigen Permanentmagneten in z-Richtung ist die Änderung der magnetischen Feldstärke am Sensor bei Betätigung der Taste nur dann linear, wenn diese in der xy-Ebene gemessen wird. Dies ermöglicht es dem Sensor, bei Betätigung der Taste ein lineares elektrisches Signal auszugeben.

Zur einfacheren Bedienung kann die Taste mit einem Bedienelement verbunden sein.

Der ringförmige Permanentmagnet ist von einem ringförmigen Schirmelement aus einem ferromagnetischen Material umgeben und mit diesem verbunden. Dies bewirkt eine magnetische Schirmung des Tasters nach Innen und nach Außen, sodass seine Funktion zum einen nicht durch äußere Magnetfelder beeinträchtigt werden kann und das Magnetfeld des Permanentmagneten die Funktion anderer, in der Nähe des Tasters angeordneter, elektronischer Vorrichtungen nicht stört. Da das ringförmige Schirmelement durch seine Verbindung mit dem ringförmigen Permanentmagneten gemeinsam mit diesem entlang der z-Achse bewegt werden kann ist eine zuverlässige magnetische Schirmung möglich, ohne die gesamte Führung mit einem magnetisch schirmenden Material bedecken zu müssen.

Das Schirmelement ist bevorzugt so dimensioniert, dass das Magnetfeld des ringförmigen Permanentmagneten darin keine magnetische Sättigung verursacht.

Weiterhin weist der Taster einen Flusskonzentrator aus einem ferromagnetischen Material auf, der eine Öffnung aufweist, durch welche die Taste entlang der z-Achse hindurchgeführt ist. Unter einem Flusskonzentrator beziehungsweise Flussleitstück wird erfindungsgemäß ein Bauteil verstanden, welches den magnetischen Fluss des darauf wirkenden Magnetfeldes des ringförmigen Permanentmagneten in sich konzentriert, beziehungsweise leitet. Der Flusskonzentrator hat bevorzugt eine magnetische Permeabilität µ von mehr als 300 H/m. Seine magnetische Koerzitivfeldstärke beträgt vorzugsweise weniger als 1000 A/m. Weiterhin ist bevorzugt, dass der Flusskonzentrator so dimensioniert ist, dass das Magnetfeld des ringförmigen Permanentmagneten darin keine magnetische Sättigung verursacht.

Der Flusskonzentrator ist so angeordnet, dass in einer Grundposition des Tasters, das Schirmelement magnetisch an dem Flusskonzentrator haftet und in einer Betätigungsposition des Tasters in der, entlang der z-Achse, in der Richtung des mindestens einen Sensors, eine Kraft auf die Taste wirkt, das Schirmelement von dem Flusskonzentrator gelöst ist und die Taste, der ringförmige Magnet und das Schirmelement gegenüber der Grundposition entlang der z-Achse, in der Richtung des mindestens einen Sensors verschoben sind. Ein Bediener muss also mit einer bestimmten Mindestkraft auf die Taste des Tasters drücken, um das Schirmelement vom Flusskonzentrator zu lösen. Hierdurch wird ein Klickeffekt erzeugt, der dem Bediener eine haptische Rückmeldung über die Betätigung des Tasters liefert. Da bei Aufwenden einer hinreichend großen Kraft eine schlagartige Wegbewegung der Taste vom Flusskonzentrator erfolgt, kann es zu keinem Prellen des Tasters kommen.

Besonders bevorzugt ist die magnetische Rückstellkraft des ringförmigen Magneten so hoch, dass der Taster, ohne Einwirkung der Kraft auf die Taste, selbsttätig aus seiner Betätigungsposition in seine Grundposition zurückkehrt. Hierzu besteht der Permanentmagnet bevorzugt aus einer NdFeB-Legierung, insbesondere mit einer Sättigungsflussdichte Bs im Bereich von 1,0 bis 1,4 T oder aus einer SmCo-Legierung, insbesondere mit einer Sättigungsflussdichte Bs im Bereich von 0,9 bis 1,2 T. Besonders bevorzugt besteht der Permanentmagnet aus einer kunststoffgebundenen NdFeB-Legierung, insbesondere mit einer Sättigungsflussdichte Bs von 670 mT. Hierdurch ist es möglich auf ein Federsystem zum Zurückführen der Taste in ihre Ausgangsposition zu verzichten.

Die Führung weist vorzugsweise einen Anschlag auf, der die maximale Auslenkung des Schirmelements entlang der z-Achse in Richtung des mindestens einen Sensors begrenzt. Hierdurch wird insbesondere sichergestellt, dass die Taste nicht soweit ausgelenkt werden kann, dass sie nicht mehr selbsttätig in ihre Grundposition zurückkehrt. Auch ein Kontakt zwischen der Taste und dem Sensor kann so vermieden werden.

Der Anschlag kann einstückig mit der Führung ausgebildet sein. Er kann jedoch auch als separates Bauteil ausgeführt sein. Bevorzugt handelt es sich hierbei um eine Leiterplatte. Dies ermöglicht es insbesondere auf der Leiterplatte mindestens eine Lichtquelle, bevorzugt mindestens eine LED, anzuordnen. Wenn die Taste aus einem transparenten oder transluzenten Material besteht, strahlt das Licht der Lichtquelle durch den Innenraum des ringförmigen Permanentmagneten und durch die Taste, so dass dies auch in dunkler Umgebung erkennbar ist. Hierzu ist die Lichtquelle bevorzugt unterhalb des Innenraum des ringförmigen Permanentmagneten angeordnet so dass das Licht senkrecht zu der Leiterplatte die Taste beleuchten kann.

Der mindestens eine Sensor ist bevorzugt ein Messelement, das den magnetoresistiven Effekt oder den Hall-Effekt ausnutzt. Besonders bevorzugt handelt es sich um ein Hall-Element. Ganz besonders bevorzugt handelt es sich um ein programmierbares Hall-Element, so dass die Änderung des magnetischen Feldes in radialer Richtung in einer x-y-Ebene als Schaltsignal ausgegeben werden kann.

Weiterhin ist es bevorzugt, dass der Taster mindestens zwei Sensoren aufweist. Dies führt zu einer Redundanz bei der Bestimmung der Tastenauslenkung, sodass der Taster weniger fehleranfällig ist.

### Kurze Beschreibung der Zeichnungen

Ausführungsbeispiele der Erfindung sind in Zeichnungen dargestellt und in den nachfolgenden Beschreibungen näher erläutert.
Figur 1 zeigt eine Querschnittsdarstellung eines Tasters gemäß einer Ausführungsform der Erfindung in einer Grundposition.
Figur 2 zeigt eine Querschnittsdarstellung eines Tasters gemäß einer Ausführungsform der Erfindung in einer Betätigungsposition.
Figur 3 zeigt den Verlauf magnetischer Feldlinien in einer Querschnittsdarstellung eines Tasters gemäß einer Ausführungsform der Erfindung.
Figur 4 zeigt eine Querschnittsdarstellung eines Tasters gemäß einer anderen Ausführungsform der Erfindung in einer Grundposition.

### Ausführungsbeispiele der Erfindung

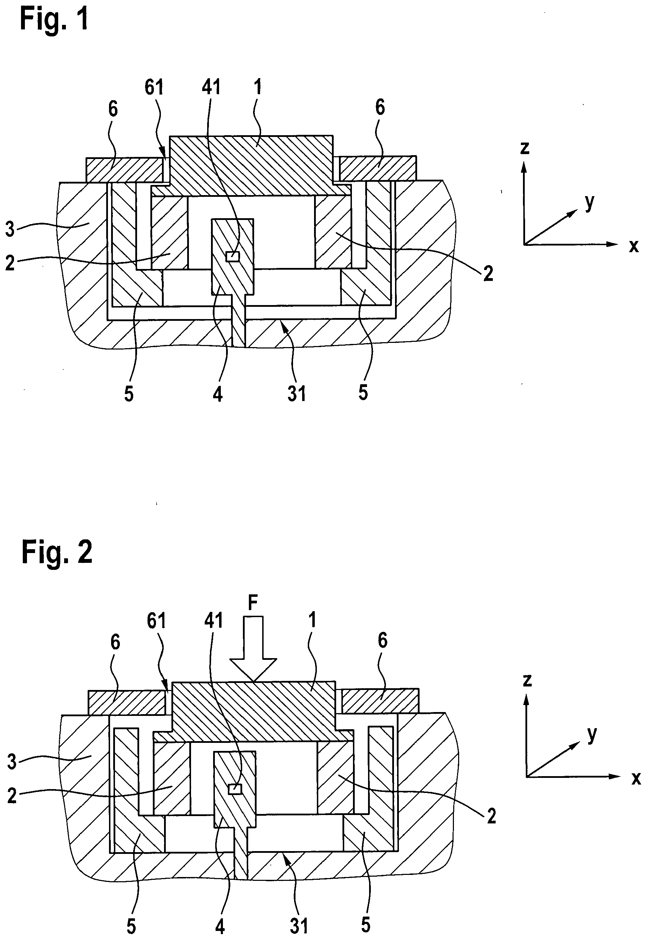

Ein Taster gemäß einer ersten Ausführungsform der Erfindung ist in Figur 1 in einer schematischen Querschnittsdarstellung gezeigt. Eine Taste 1 dient der Betätigung des Tasters durch einen Bediener. Sie ist auf einem ringförmigen Permanentmagneten 2 aus kunststoffgebundener NdFeB-Legierung befestigt. Der Permanentmagnet 2 weist einen Innendurchmesser von 5 mm ein Außendurchmesser von 8,0 mm und eine Länge von 2,5 mm auf. Der ringförmige Permanentmagnet 2 ist in einem becherförmigen Gehäuse aus einem Kunststoff angeordnet, das als Führung 3 fungiert. Ein Hall-Element 4 ist so in diesem Gehäuse angeordnet, dass sein sensitiver Bereich 41 sich im Innenraum des ringförmigen Permanentmagneten 2 befindet. Die Beine des Hall-Elements 4 sind durch den Boden des Gehäuses geführt, sodass das Hall-Element 4 von außen elektrisch kontaktiert werden kann. Der ringförmige Permanentmagnet 2 ist in einem ringförmigen Schirmelement 5 mit einer Länge von 4,5 mm so angeordnet, dass das Schirmelement 5 oben und unten über den ringförmigen Permanentmagneten 2 hinausragt. Das Schirmelement 5 hat einen Außendurchmesser von 10,5 mm und ist an den Innenwänden der Führung 3 geführt. An der Unterseite des ringförmigen Permanentmagneten 2 verringert sich der Innendurchmesser des Schirmelements 5, sodass der ringförmige Permanentmagnet 2 dort auf dem Schirmelement 5 aufliegt. Der ringförmige Permanentmagnet 2 und das Schirmelement 5 sind an dieser Auflagefläche miteinander verbunden. Die becherförmige Führung 3 wird an ihrer Oberseite durch einen scheibenförmigen Flusskonzentrator 6 aus weichmagnetischem Stahlblech verschlossen. Der Flusskonzentrator 6 weist in seiner Mitte eine durchgehende Öffnung 61 auf, durch welche die Taste 1 hindurchgeführt ist. Hierdurch ist es möglich, die Taste 1 von der Oberseite des Tasters zu betätigen. In der in Figur 1 dargestellten Grundposition des Tasters wird das Schirmelement 5 magnetisch am Flusskonzentrator 6 gehalten.

Wird von einem Bediener eine Kraft F auf die Taste 1 angewandt, so kann dieser das Schirmelement 5 vom Flusskonzentrator 6 lösen und so die Taste 1, den ringförmigen Permanentmagneten 2 und das Schirmelement 5 0,5 mm weit entlang der z-Achse des Tasters nach unten bewegen. Bei Beginn dieser Bewegung erhält der Benutzer eine haptische Rückmeldung durch die Lösung der Verbindung zwischen Schirmelement 5 und Flusskonzentrator 6. Die Abwärtsbewegung der Taste 1, des ringförmigen Permanentmagneten 2 und des Schirmelements 5 wird durch das Auftreffen des Schirmelements 5 auf den Boden der Führung 3 begrenzt. Dieser Boden fungiert somit als Anschlag 31. Lässt der Benutzer die Taste 1 los, so bewegt sich das Schirmelement 5 aufgrund der dadurch hindurch fließenden magnetischen Feldlinien des ringförmigen Permanentmagneten 2 aufwärts in Richtung des Flusskonzentrators 6 bis es wieder an diesem haftet und der Taster somit in seine, in Figur 1 dargestellte, Grundposition zurückgekehrt ist. Die Betätigung und das Loslassen der Taste 1 führen jeweils zu einer Bewegung des ringförmigen Permanentmagneten 2 entlang der z-Achse des Tasters und somit zu einer Änderung des vom Hall-Element 4 in der xy-Ebene gemessenen magnetischen Feldes. Die Information über diese Änderung kann vom Hall-Element 4 als elektrisches Signal weitergeben werden, durch dessen Auswertung erkannt werden kann, in welcher Position sich der Taster befindet.

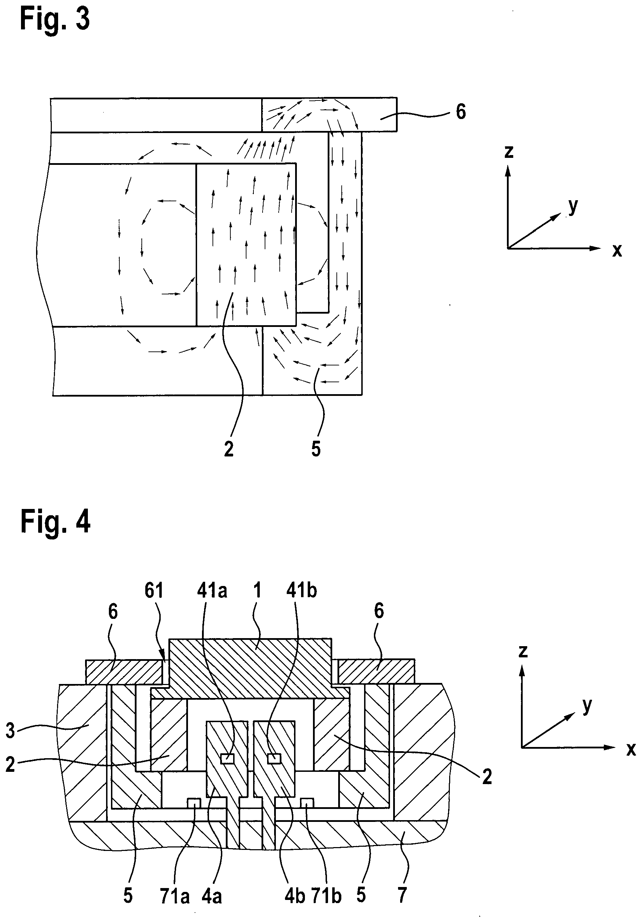

Figur 3 zeigt den Verlauf der magnetischen Feldlinien innerhalb der ferromagnetischen Teile des Tasters und innerhalb des ringförmigen Magneten 2, wenn sich der Taster in seiner Grundposition gemäß Figur 1 befindet. Da der ringförmige Permanentmagnet 2 entlang der z-Achse magnetisiert ist, suchen sich die Feldlinien den kürzesten Weg, treten also an der Oberseite des ringförmigen Permanentmagneten 2 aus und laufen durch den Luftspalt zwischen der Taste 1 und dem Flusskonzentrator 6 in den Flusskonzentrator 6, durch das Schirmelement 5 und von dort zum zweiten magnetischen Pol des ringförmigen Permanentmagneten 2 auf dessen Unterseite. Das Schirmelement 5 haftet, bedingt durch den magnetischen Fluss, an der Unterseite des Flusskonzentrators 6.

In einer zweiten in Fig. 4 dargestellten Ausführungsform des erfindungsgemäßen Tasters ist das einzelne Hall-Element 4 durch zwei Hall-Elemente 4a, 4b mit jeweils einem sensitiven Bereich 41a, 41b ersetzt. Hierdurch ist eine redundante Messung der magnetischen Feldänderung in radialer Richtung in der x-y-Ebene möglich, was die Zuverlässigkeit des erfindungsgemäßen Tasters erhöht. Als Führung 3 wird anstelle des becherförmigen Gehäuses ein ringförmiges Gehäuse verwendet. Eine Leiterplatte 7 fungiert als Anschlag für das Schirmelement 5. Auf der Leiterplatte 7 sind zwei LEDs 71a, 71b unterhalb des Innenraums des ringförmigen Permanentmagneten 2 angeordnet. Die Taste 1 besteht aus einem transluzenten Kunststoff. Dies ermöglicht eine Beleuchtung der Taste. Taster gemäß der zweiten Ausführungsform der Erfindung können auch in dunkler Umgebung bedient werden.

## Patentansprüche

1. Taster, umfassend
- eine Taste (1) die mit einem ringförmigen Permanentmagneten verbunden (2) ist, der entlang einer z-Achse magnetisiert ist,
- eine Führung (3) aus einem nicht ferromagnetischen Material, in der die Taste (1) und der ringförmige Permanentmagnet (2) entlang der z-Achse bewegbar angeordnet sind, und
- mindestens einen Sensor (4, 4a, 4b), dessen sensitiver Bereich (41, 41a, 41b) im ringförmigen Permanentmagneten angeordnet ist und der eingerichtet ist, um eine Änderung eines magnetischen Feldes in radialer Richtung in einer
x-y-Ebene zu messen, wobei die x-Achse und die y-Achse jeweils orthogonal auf der z-Achse stehen,
- ein ringförmiges Schirmelement (5) aus einem ferromagnetischen Material, das den ringförmigen Permanentmagneten (2) umgibt und mit diesem verbunden ist und
- einen Flusskonzentrator (6) aus einem ferromagnetischen Material, der eine Öffnung (61) aufweist, durch welche die Taste (1) entlang der z-Achse hindurchgeführt ist,
**dadurch gekennzeichnet, dass** der Flusskonzentrator (6) so angeordnet ist, dass
- in einer Grundposition des Tasters das Schirmelement (5) magnetisch an dem Flusskonzentrator (6) haftet, und
- in einer Betätigungsposition des Tasters, in der entlang der z-Achse in Richtung des mindestens einen Sensors eine Kraft auf die Taste (1) wirkt, das Schirmelement (5) von dem Flusskonzentrator (6) gelöst ist und die Taste (1), der ringförmige Magnet (2) und das Schirmelement (5) gegenüber der Grundposition entlang der z-Achse in Richtung des mindestens einen Sensors (4, 4a, 4b) verschoben sind.

2. Taster nach Anspruch 1, **dadurch gekennzeichnet, dass** das Schirmelement (5) so dimensioniert ist, dass das Magnetfeld des ringförmigen Permanentmagneten (2) darin keine magnetische Sättigung verursacht.

3. Taster nach Anspruch 1 oder 2, **dadurch gekennzeichnet, dass** der Flusskonzentrator (6) so dimensioniert ist, dass das Magnetfeld des ringförmigen Permanentmagneten (2) darin keine magnetische Sättigung verursacht.

4. Taster nach einem der Ansprüche 1 bis 3, **dadurch gekennzeichnet, dass** die magnetische Rückstellkraft des ringförmigen Magneten (2) so hoch ist, dass der Taster ohne Einwirkung der Kraft auf die Taste (1) selbsttätig aus seiner Betätigungsposition in seine Grundposition zurückkehrt.

5. Taster nach einem der Ansprüche 1 bis 4, **dadurch gekennzeichnet, dass** die Führung (3) einen Anschlag (31, 7) aufweist, der die maximale Auslenkung des Schirmelements (5) entlang der z-Achse in Richtung des mindestens einen Sensors (4, 4a, 4b) begrenzt.

6. Taster nach Anspruch 5, **dadurch gekennzeichnet, dass** der Anschlag (7) eine Leiterplatte ist.

7. Taster nach Anspruch 6, **dadurch gekennzeichnet, dass** mindestens eine Lichtquelle (71a, 71b) auf der Leiterplatte angeordnet ist.

8. Taster nach einem der Ansprüche 1 bis 7, **dadurch gekennzeichnet, dass** der mindestens eine Sensor (4, 4a, 4b) ein Hall-Element ist.

9. Taster nach einem der Ansprüche 1 bis 8, **dadurch gekennzeichnet, dass** er mindestens zwei Sensoren (4a, 4b) aufweist.

## Claims

1. Switch, comprising
- a button (1) which is connected to a ring-shaped permanent magnet (2) that is magnetised along a z-axis,
- a guide member (3) made from a non-ferromagnetic material inside which the button (1) and the ring-shaped permanent magnet (2) are arranged in such a manner as to be moveable along the z-axis, and
- at least one sensor (4, 4a, 4b) that has a sensitive area (41, 41a, 41b) which is arranged in the ring-shaped permanent magnet and that is configured to measure a change in a magnetic field in the radial direction of a x-y-plane, wherein the x-axis and the y-axis lie orthogonally to the z-axis, respectively,
- a ring-shaped shielding element (5) that is made from a ferromagnetic material, which encloses the ring-shaped permanent magnet (2) and is connected to the same, and
- a flux concentrator (6) that is made from a ferromagnetic material and has an opening (61) through which the button (1) is guided along the z-axis,
**characterised in that** the flux concentrator (6) is arranged in such a way that
- in a base position of the switch, the shielding element (5) magnetically adheres to the flux concentrator (6), and
- in an actuation position of the switch, in which a force is applied to the button (1) along the z-axis in the direction of the at least one sensor, the shielding element (5) is released from the flux concentrator (6) and the button (1), the ring-shaped magnet (2) and the shielding element (5) are shifted with regard to the basic position along the z-axis in the direction of the at least one sensor (4, 4a, 4b).

2. Switch according to claim 1, **characterised in that** the dimensions of the shielding element (5) are chosen in in such a way that the magnetic field of the ring-shaped permanent magnet (2) does not cause any magnetic saturation therein.

3. Switch according to claim 1 or 2, **characterised in that** the dimensions of the flux concentrator (6) are chosen in such a way that the magnetic field of the ring-shaped permanent magnet (2) does not cause any magnetic saturation therein.

4. Switch according to one of claims 1 to 3, **characterised in that** the magnetic reset force of the ring-shaped magnet (2) is so high, that the switch automatically returns from its actuating position to its basic position without any force being applied to the button (1).

5. Switch according to one of claims 1 to 4, **characterised in that** the guide member (3) has a stop collar (31,7) that limits the maximum deflection of the shielding element (5) along the z-axis in the direction of the at least one sensor (4, 4a, 4b).

6. Switch according to claim 5, **characterised in that** the stop collar (7) is a circuit board.

7. Switch according to claim 6, **characterised in that** at least one light source (71a, 71b) is arranged on the circuit board.

8. Switch according to one of claims 1 to 7, **characterised in that** the at least one sensor (4, 4a, 4b) is a Hall element.

9. Switch according to one of claims 1 to 8, **characterised in that** it has at least two sensors (4a, 4b).

## Revendications

1. Bouton, comprenant
- une touche (1) reliée à un aimant permanent annulaire (2) qui est aimanté le long de l'axe z,
- une coulisse (3) en matière non ferromagnétique dans laquelle la touche (1) et l'aimant permanent annulaire (2) sont agencés mobiles le long de l'axe z, et
- au moins un capteur (4, 4a, 4b) dont la plage de sensibilité (41, 41a, 41b) est située dans l'aimant permanent annulaire et qui est installé pour pouvoir mesurer une modification du champ magnétique dans le sens radial dans un plan x-y ; l'axe x et l'axe y étant chacun orthogonal à l'axe z,
- un élément de blindage annulaire (5) en matière ferromagnétique, qui entoure l'aimant permanent annulaire (2) et est relié à celui-ci, et
- un concentrateur de flux (6) en matière ferromagnétique, lequel présente une ouverture (61) à travers laquelle la touche (1) peut coulisser selon l'axe z,
**caractérisé en ce que** le concentrateur de flux (6) est agencé de manière que :
- dans une position de base du bouton, l'élément de blindage (5) adhère par voie magnétique au concentrateur de flux (6), et
- dans une position d'activation du bouton, dans laquelle une force agit sur la touche (1) selon l'axe z en direction de l'au moins un capteur, l'élément de blindage (5) se détache du concentrateur de flux (6), et la touche (1), l'aimant annulaire (2) et l'élément de blindage (5) quittent la position de base et se déplacent le long de l'axe z en direction de l'au moins un capteur (4, 4a, 4b).

2. Bouton selon la revendication 1, **caractérisé en ce que** l'élément de blindage (5) est de dimensions telles que le champ magnétique de l'aimant permanent annulaire (2) n'y occasionne aucune saturation magnétique.

3. Bouton selon la revendication 1 ou 2, **caractérisé en ce que** le concentrateur de flux (6) est de dimensions telles que le champ magnétique de l'aimant permanent annulaire (2) n'y occasionne aucune saturation magnétique.

4. Bouton selon l'une des revendications 1 à 3, **caractérisé en ce que** la force de rappel magnétique de l'aimant annulaire (2) est d'un niveau tel que le bouton revient automatiquement de sa position d'activation à sa position de base, sans exercice de force sur la touche (1).

5. Bouton selon l'une des revendications 1 à 4, **caractérisé en ce que** la coulisse (3) présente une butée (31, 7) qui limite la déviation maximale de l'élément de blindage (5) dans l'axe z en direction de l'au moins un capteur (4, 4a, 4b).

6. Bouton selon la revendication 5, **caractérisé en ce que** la butée (7) est une carte imprimée.

7. Bouton selon la revendication 6, **caractérisé en ce qu'**au moins une source de lumière (71a, 71b) est prévue sur la carte imprimée.

8. Bouton selon l'une des revendications 1 à 7, **caractérisé en ce que** l'au moins un capteur (4, 4a, 4b) est un élément à effet de Hall.

9. Bouton selon l'une des revendications 1 à 8, **caractérisé en ce qu'**il présente au moins deux capteurs (4a, 4b).
